# DEMANDE DE BREVET EUROPEEN

(11) **EP 2 381 745 A1**
(43) Date de publication de la demande: **26.10.2011**
(21) Numéro de dépôt: 11172746.7
(22) Date de dépôt: 05.09.2007
(51) Int. Cl.: H05B 33/26, B32B 17/10, H05B 33/28, H01L 51/52, G02F 1/1343, H01J 1/30

(54) **Substrat pour dispositif electroluminescent organique, utilisation et procede de fabrication de ce substrat, ainsi que dispositif electroluminescent organique**

(30) Priorité: 07.09.2006 FR 0653617; 17.11.2006 FR 0654952
(62) Demande divisionnaire de: 07823773.2
(71) Demandeur: Saint-Gobain Glass France, 92400 Courbevoie (FR)
(72) Inventeur: Tchakarov, Svetoslav, 92330 SCEAUX (FR); Gerardin, Hadia, 75012 PARIS (FR); Reutler, Pascal, 75019 PARIS (FR); Jousse, Didier, 95150 TAVERNY (FR); Mattmann, Eric, 75013 PARIS (FR); Nael, Pascal, 93300 AUBERVILLIERS (FR)
(74) Mandataire: Neuviale, Bertrand

(57) **Abrégé**

L'invention se rapporte à un substrat (1) pour dispositif électroluminescent organique (10) comportant sur un revêtement électrode (3) inférieur constitué d'un empilement de couches minces comportant:
- une couche de contact (31) à base d'oxyde métallique et/ou de nitrure métallique,
- une couche fonctionnelle métallique (32) à propriété intrinsèque de conductivité électrique, la couche fonctionnelle (32) est à base d'un matériau choisi parmi l'argent, l'or, l'aluminium, le cuivre
- une surcouche (34) à base d'oxyde métallique et/ou de nitrure métallique, notamment d'adaptation du travail de sortie pour ledit revêtement électrode,
ledit substrat comportant une couche de fond (2), ladite couche de fond (2) couvrant ladite face principale (11).

## Description

La présente invention a pour objet une électrode multicouche, sa gravure acide ainsi que des dispositifs électroluminescents organiques l'incorporant.

Les systèmes électroluminescents organiques connus ou OLED (pour « Organic Light Emitting Diodes » en anglais) comportent un matériau ou un empilement de matériaux électroluminescents organiques alimenté en électricité par des électrodes généralement sous forme de deux couches électroconductrices l'encadrant.

Ces couches électroconductrices comportent communément une couche à base d'oxyde d'indium, généralement l'oxyde d'indium dopé à l'étain plus connu sous l'abréviation ITO. Les couches ITO ont été particulièrement étudiées. Elles peuvent être aisément déposées par pulvérisation cathodique assistée par champ magnétique, soit à partir d'une cible d'oxyde (pulvérisation non réactive), soit à partir d'une cible à base d'indium et d'étain (pulvérisation réactive en présence d'un agent oxydant du type oxygène) et leur épaisseur est de l'ordre de 100 à 150 nm. Cependant, cette couche d'ITO présente un certain nombre d'inconvénients. En premier lieu, la matière et le procédé de dépôt à température élevée (350°C) pour améliorer la conductivité engendrent des surcoûts. La résistance par carré reste relativement élevée (de l'ordre de 10 Ω par carré) à moins d'augmenter l'épaisseur des couches au-delà de 150 nm ce qui résulte en une diminution de la transparence et en une augmentation de la rugosité de surface.

Aussi, de nouvelles structures d'électrode se développent. On connaît par exemple par le document JP2005-038642 un écran plat électroluminescent TFT (« thin-film transistor » en anglais) comportant des systèmes électroluminescents organiques à émission par le haut (« top emission » en anglais) générant respectivement, une lumière rouge, une lumière verte, et une lumière bleue, pour former une matrice active.

Chaque dispositif organique électroluminescent est pourvu d'une électrode dite inférieure ou arrière (ou « bottom etectrode » en anglais), comportant :
- une couche d'adhésion, par exemple en ITO,
- une couche métallique (semi)réfléchissante notamment à base d'argent, d'aluminium, ou en argent contenant de l'aluminium, d'épaisseur au moins égale à 50 nm,
- une surcouche d'adaptation du travail de sortie, par exemple en ITO.

Le but que se fixe la présente invention est de parvenir à obtenir un assemblage de couches électroconductrices pour former une électrode fiable, robuste (notamment en termes de stabilité et/ou de tenue mécanique, thermique) sans sacrifier ses propriétés d'électroconductivité, sa qualité optique, ni les performances du dispositif l'incorporant, ni engendrer des difficultés de réalisation.

Le but que se fixe l'invention est en particulier de parvenir à obtenir un assemblage de couches électroconductrices pour former une électrode inférieure d'un système électroluminescent fiable, robuste sans sacrifier ses propriétés d'électroconductivité, sa qualité optique, ni les performances optiques de l'OLED, ni engendrer des difficultés de réalisation.

Par électrode inférieure au sens de l'invention il faut comprendre que l'on fait référence à l'électrode intercalée entre le substrat porteur et le système OLED.

Accessoirement, il s'agit d'atteindre cet objectif sans bouleverser les configurations connues des systèmes électroluminescents organiques concernant l'invention, et à moindre coût.

Il s'agit de mettre au point des électrodes essentiellement transparentes, ou à la fois transparentes et réfléchissante ou essentiellement réfléchissantes, qui conviennent aussi bien pour des OLEDS formant des écrans OLED à matrice active et aussi passive, ou formant des dispositifs de rétro-éclairage d'écrans vidéo ou utilisés dans des applications d'éclairage général (architectural et/ou décoratif) ou de signalétique voire même pour d'autres applications électroniques.

Ce nouveau revêtement électrode peut en particulier présenter des propriétés optiques adéquates pour être utilisé comme face avant, c'est-à-dire la (ou les) face(s) par laquelle (ou lesquelles) la lumière produite par le système OLED sort du dispositif. Il peut en particulier présenter une transmission lumineuse suffisante combinée à une absorption la plus faible possible. En effet, il est apparu qu'il n'est pas nécessaire de viser une transmission lumineuse la plus élevée possible pour obtenir la puissance lumineuse maximale en sortie du dispositif OLED, mais qu'en revanche, pour la face avant il est nécessaire d'avoir une absorption la plus faible possible.

La présente invention consiste ainsi aussi à choisir un empilement de couches minces qui est compatible avec le procédé de fabrication du dispositif électroluminescent organique et en particulier avec l'étape de formation par gravure de l'électrode inférieure avant dépôt du système OLED.

La présente invention entend remédier aux inconvénients de l'art antérieur en proposant une nouvelle solution pour la réalisation d'un revêtement électrode inférieure pour un dispositif électroluminescent organique.

A cet effet, l'invention a pour objet un substrat selon la revendication 1, une utilisation d'un substrat et notamment de ce substrat selon la revendication 22, un dispositif électroluminescent organique comportant ce substrat ou utilisant ce substrat selon la revendication 24 et un procédé de fabrication de ce substrat selon la revendication 29.

Les revendications dépendantes de ces revendications définissent des alternatives avantageuses à l'invention.

L'invention a ainsi pour objet, dans son acception la plus large, un substrat pour dispositif électroluminescent organique, notamment un substrat verrier transparent, comportant sur une première face principale un revêtement électrode inférieur, le revêtement électrode étant constitué d'un empilement de couches minces comportant successivement au moins :
- une couche de contact à base d'oxyde métallique et/ou de nitrure métallique,
- une couche fonctionnelle métallique à propriété intrinsèque de conductivité électrique,
- une surcouche à base d'oxyde métallique et/ou de nitrure métallique, notamment d'adaptation du travail de sortie pour ledit revêtement électrode,
le substrat comportant une couche de fond, ladite couche de fond couvrant ladite face principale du substrat.

La couche de fond selon l'invention présente un double effet : elle forme à la fois une barrière aux alcalins qui pourraient venir du substrat et constitue une couche antireflet essentielle pour la microcavité du système OLED.

Le revêtement électrode selon l'invention est ainsi constitué d'un empilement de couches minces comportant au moins une couche fonctionnelle métallique, notamment à base d'argent (c'est-à-dire en argent ou en alliage métallique contenant majoritairement de l'argent), et au moins un revêtement antireflet inférieur disposé entre le substrat et cette couche fonctionnelle métallique, ce revêtement antireflet comportant au moins une couche diélectrique antireflet : la couche de fond.

Par « revêtement » au sens de la présente invention, il faut comprendre qu'il peut y avoir une couche en un matériau unique ou plusieurs couches, chacune en un matériau différent.

Le but de ce revêtement antireflet sous la couche fonctionnelle métallique en direction du substrat et au contact du substrat est de rendre le rayonnement émis par le système OLED peu sélectif en longueur d'onde et peu dépendant de l'angle d'observation.

En effet, en l'absence de ce revêtement antireflet, d'une part la lumière émise par le système OLED est très centrée sur la longueur d'onde ou la plage très mince de longueurs d'ondes d'émission du système OLED et d'autre part la couleur et la puissance de cette lumière varient fortement en fonction de l'angle d'observation.

Ce type d'empilement de couches minces est connu dans le domaine des vitrages de bâtiments ou de véhicules pour réaliser des vitrages d'isolation thermique renforcée du type « bas-émissif » et/ou de « contrôle solaire ».

Les inventeurs se sont ainsi aperçus que certains empilements utilisés pour les vitrages bas-émissifs en particulier étaient aptes à être utilisés pour réaliser la couche de fond et le revêtement électrode pour des dispositifs électroluminescents organiques et notamment la couche de fond et le revêtement électrode pour la (ou les) face(s) avant(s) de ces dispositifs.

Les empilements connus sous le nom d'empilements « trempables » ou « à tremper », c'est-à-dire ceux utilisés lorsqu'il est souhaité faire subir un traitement thermique de trempe au substrat porteur de l'empilement sont en particulier adéquats ; ceci est d'autant plus surprenant que le substrat pour dispositif électroluminescent organique n'a pas à subir de traitement thermique pour sa mise en oeuvre dans ce dispositif, ou en tout cas pas de traitement thermique suffisamment chaud avec un refroidissement suffisamment brusque pour réaliser un traitement de trempe du substrat verrier.

La présente invention a ainsi aussi pour objet, l'utilisation d'un empilement de couches minces pour vitrage architectural ou l'utilisation d'un substrat revêtu d'un empilement de couches minces pour vitrage architectural, notamment un empilement ou substrat revêtu bas-émissif et/ou notamment un empilement ou substrat revêtu « trempable » ou « à tremper », pour réaliser un substrat selon l'invention pour un dispositif électroluminescent organique.

Par empilement ou substrat « trempable » au sens de la présente invention, il faut comprendre que les propriétés optiques et les propriétés thermiques (exprimées par la résistance par carré qui est liée directement à l'émissivité) essentielles sont conservées pendant le traitement thermique.

Ainsi, il est possible sur une même façade de bâtiment par exemple de disposer à proximité les uns des autres des vitrages intégrant des substrats trempés et des substrats non trempés, tous revêtus du même empilement, sans qu'il ne soit possible de les distinguer les uns des autres par une simple observation visuelle de la couleur en réflexion et/ou de la réflexion/transmission lumineuse.

Par exemple, un empilement ou un substrat revêtu d'un empilement qui présente les variations avant / après traitement thermique suivantes sera considéré comme trempable car ces variations ne seront pas perceptibles à l'oeil :
- une variation de transmission lumineuse ΔT_{L} faible, inférieure à 3 % voire 2 % ; et/ou
- une variation de réflexion lumineuse ΔR_{L} faible, inférieure à 3 % voire 2 % ; et/ou
- une variation de couleur ΔE =√((ΔL*)²+(Δa*)²+(Δb*)²) faible, inférieure à 3, voire 2.

Par empilement ou substrat « à tremper » au sens de la présente invention, il faut comprendre que les propriétés optiques et thermiques du substrat revêtu sont acceptables après traitement thermique alors qu'elles ne le sont pas, ou en tout cas pas toutes, auparavant.

Par exemple, un empilement ou un substrat revêtu d'un empilement qui présente après le traitement thermique les caractéristiques suivantes sera considéré comme « à tremper » dans le cadre de la présente invention, alors qu'avant le traitement thermique au moins une de ces caractéristiques n'était pas remplie :
- une transmission lumineuse élevée T_{L} d'au moins 50, voire d'au moins 60% ou 65, voire 70 %, voire d'au moins 75 % et de préférence encore d'au moins 80 %; et/ou
- une résistance par carré R au moins aussi bonne que celle de L'ITO aux épaisseurs habituelles, et en particulier inférieure à 20 Ω/, voire inférieure à 15 Ω/.

L'important est que le revêtement électrode utilisé pour la face avant soit d'une part suffisamment transparent tel qu'il présente avant le dépôt du système OLED une transmission lumineuse d'au moins 50 % et de préférence comprise entre 60 et 70 % et d'autre part très peu absorbant tel qu'il présente avant le dépôt du système OLED une absorption définie comme étant 1-R_{L}-T_{L} inférieure ou égale à 15 %, voire inférieure ou égale à 10 %, voire inférieure ou égale à 8 %, voire inférieure ou égale à 5 %.

Une transmission lumineuse supérieur à 70 % est à éviter si elle implique que pour obtenir cette valeur l'épaisseur du revêtement de couches minces situé entre la couche fonctionnelle métallique et le système OLED (surcouche et éventuelle(s) autre(s) couche(s)) présente une épaisseur trop important qui est susceptible de nuire aux performances de l'OLED en espaçant trop la couche fonctionnelle métallique du système OLED.

La couche de fond peut être :
- à base d'oxyde de silicium (de formule générale SiO),
- à base d'oxycarbure de silicium (de formule générale SiOC),
- à base de nitrure de silicium (de formule générale SiN), en particulier à base de Si₃N₄,
- à base d'oxynitrure de silicium (de formule générale SiON),
- à base d'oxycarbonitrure de silicium (de formule générale SiONC).

Il est possible que la nitruration de la couche de fond soit légèrement sous stoechiométrique.

La couche de fond présente de préférence une épaisseur comprise entre 10 et 150 nm, encore plus préférentiellement entre 20 et 100 nm.

La couche de fond confère à l'électrode selon l'invention de nombreux atouts. Elle est d'abord une barrière aux alcalins sous jacents à l'électrode. Elle protège de toute pollution la couche de contact sus-jacente (pollutions qui peuvent entraîner des défauts mécaniques tels que des délaminations) ; elle préserve en outre la conductivité électrique de la couche fonctionnelle métallique. Elle évite aussi que la structure organique d'un dispositif OLED ne soit polluée par les alcalins réduisant de fait considérablement la durée de vie de l'OLED.

La migration des alcalins peut intervenir pendant la fabrication du dispositif, engendrant un manque de fiabilité, et/ou postérieurement, réduisant sa durée de vie.

La couche de fond améliore les propriétés d'accrochage de la couche de contact sans accroître notablement la rugosité de l'ensemble de l'empilement de couches, même en cas d'interposition d'une ou de plusieurs couche entre la couche de fond et la couche de contact.

L'invention trouve naturellement un intérêt tout particulièrement pour une électrode qui se trouve la plus proche du substrat porteur susceptible de relarguer des alcalins tel que le verre silicosodocalcique notamment clair, extraclair.

Par ailleurs, grâce à cette structure particulière d'empilement, on obtient en outre une électrode fiable, permettant des gains de productivité significatifs.

On obtient en outre, à moindre coût, une électrode présentant une compatibilité des propriétés de surface avec les systèmes électroluminescents organiques tout en ayant des propriétés de conductivité électrique et/ou de transparence ou de réflectivité ajustables à façon, notamment en jouant sur l'épaisseur de la couche métallique, voire des autres couches et/ou sur les conditions de dépôt.

Pour une structure organique donnée d'un dispositif OLED, l'électrode de l'invention permet d'améliorer le rendement en lm/W de l'OLED d'au moins 5 à 10% et jusqu'à 15 voire 20 %, pour une brillance supérieure à 500 cd/m² par rapport à une électrode en ITO aux épaisseurs habituelles.

Le revêtement électrode peut comprendre de manière préférentielle une couche d'arrêt de gravure entre la couche de fond et la couche de contact, notamment une couche à base d'oxyde d'étain, cette couche d'arrêt de gravure étant notamment d'épaisseur entre 10 et 100 nm, encore plus préférentiellement entre 20 et 60 nm.

Tout particulièrement, par souci de simplicité, la couche d'arrêt de gravure peut faire partie ou être la couche de fond : elle peut être de préférence être à base de nitrure de silicium ou elle peut être une couche qui est à base de d'oxyde de silicium ou à base d'oxynitrure de silicium ou à base d'oxycarbure de silicium ou encore à base d'oxycarbonitrure de silicium et avec de l'étain pour renforcer par propriété d'anti gravure, couche de formule générale SnSiOCN.

La couche d'arrêt de gravure sert à protéger le substrat dans le cas d'une gravure chimique ou une gravure par plasma réactif.

Grâce à la couche d'arrêt de gravure, la couche de fond reste présente même dans la les zones gravées (« patterned » en anglais). Aussi, la migration des alcalins, par effet de bord, entre le substrat dans une zone gravée et une partie d'électrode adjacente (voire une structure organique) peut être stoppée.

On peut préférer tout particulièrement une couche de fond / arrêt de gravure (essentiellement) en nitrure de silicium Si₃N₄, dopé ou non. Le nitrure de silicium est très rapide à déposer et forme une excellente barrière aux alcalins. En outre, grâce à son indice optique élevé par rapport au substrat porteur, il permet d'adapter les propriétés optiques de l'électrode en jouant de préférence sur l'épaisseur de cette couche de fond / arrêt de gravure. Cela permet ainsi d'ajuster par exemple la couleur en transmission lorsque l'électrode est transparente ou en réflexion lorsque la face opposée du substrat porteur est un miroir.

La couche fonctionnelle est, de préférence, à base d'un matériau pur choisi parmi l'argent, l'or, l'aluminium, le cuivre, ou à base dudit matériau allié ou dopé avec un autre matériau choisi parmi : Ag, Au, Pd, Al, Pt, Cu, Zn, Cd, In, Si, Zr, Mo, Ni, Cr, Mg, Mn, Co, Sn, notamment est à base d'un alliage or et argent ou d'un alliage or et cuivre.

L'empilement de couches minces réalisant le revêtement électrode est de préférence un revêtement monocouche fonctionnelle, c'est-à-dire à une seule couche fonctionnelle ; toutefois, il peut être pluri-couches fonctionnelles et notamment bi-couches fonctionnelles.

Pour réaliser un revêtement électrode pluri-couches fonctionnelles, sur la couche de fond et l'éventuelle couche d'arrêt de gravure, est agencé n fois la structure suivante, avec n un nombre entier supérieur ou égal à 1 : la couche de contact, la couche métallique fonctionnelle, la structure étant surmontée d'une séquence comprenant la succession constituée au moins de : couche de contact / couche métallique fonctionnelle / surcouche.

L'électrode selon l'invention peut être sur une grande surface par exemple une surface supérieure ou égale à 0,02 m² voire même supérieure ou égale à 0,5 m² ou supérieure ou égale à 1 m².

Avantageusement, l'électrode selon l'invention peut présenter :
- une résistance par carrée inférieure ou égale à 10 Ω/carré pour une épaisseur de couche fonctionnelle à partir de 6 nm, de préférence inférieure ou égale à 5 Ω/carré pour une épaisseur de couche fonctionnelle à partir de 10 nm, combinée de préférence aux propriétés optiques suivantes :
   - une transmission lumineuse T_{L} supérieure ou égale à 50% et de préférence comprise entre 60% et 70 %, voire plus si cela ne nuit pas aux performances lumineuses de l'OLED et
   - une absorption inférieure ou égale à 15 %, voire inférieure ou égale à 10 % ou encore plus préférentiellement inférieure ou égale à 8%, voire à 5 %,
ce qui rend son utilisation en tant qu'électrode transparente particulièrement satisfaisante,
- une résistance par carré inférieure ou égale à 1 Ω/carré pour une épaisseur de couche fonctionnelle à partir de 50 nm, de préférence inférieure ou égale à 0,6 Ω/carré, combinée de préférence une réflexion lumineuse R_{L} supérieure ou égale à 70%, encore plus préférentiellement à 80%, ce qui rend son utilisation en tant qu'électrode réfléchissante particulièrement satisfaisante,
- une résistance par carré inférieure ou égale à 3 Ω/carré pour une épaisseur de couche fonctionnelle à partir de 20 nm, de préférence inférieure ou égale à 1,8 Ω/carré, combinée de préférence un rapport T_{L} sur R_{L} entre 0,1 et 0,7, ce qui rend son utilisation en tant qu'électrode transparente/réfléchissante particulièrement satisfaisante.

L'épaisseur de la couche fonctionnelle métallique (ou de toutes ces couches) choisie(s) à base d'argent peut être comprise pour une électrode (au total) entre 3 à 20 nm, préférentiellement comprise entre 5 à 15 nm. Dans cette gamme d'épaisseurs, l'électrode peut atteindre une transparence suffisante grâce au revêtement antireflet sous-jacent à la (ou chaque) couche fonctionnelle métallique à base d'argent afin de permettre de réaliser une électrode transparente particulièrement satisfaisante, comme mentionné dans le paragraphe précédent.

Il n'est cependant pas exclu d'avoir une couche fonctionnelle métallique (ou de toutes ces couches) choisie(s) à base d'argent nettement plus épaisse(s) notamment dans le cas où le système électroluminescent organique fonctionne en réflexion, ou à émission par le haut. L'épaisseur de la couche fonctionnelle (ou de toutes ces couches) choisie(s) à base d'argent peut dans ce cas pour une électrode (au total) être comprise entre 50 et 150 nm, préférentiellement comprise entre 80 à 100 nm afin de permettre de réaliser une électrode réfléchissante particulièrement satisfaisante, comme mentionné précédemment.

L'épaisseur de la couche fonctionnelle (ou de toutes ces couches) choisie(s) à base d'argent peut en outre être comprise pour une électrode (au total) entre 20 à 50 nm pour que l'électrode fonctionne à la fois en transmission et en réflexion afin de permettre de réaliser une électrode transparente/réfléchissante particulièrement satisfaisante, comme mentionné précédemment.

La (ou chaque) couche fonctionnelle métallique, notamment à base d'argent, est, de préférence, déposée sous une forme cristallisée sur une couche diélectrique mince qui est également de préférence cristallisée. La couche de contact favorise ainsi l'orientation cristalline adéquate de la couche métallique déposée dessus.

La couche fonctionnelle est ainsi, de préférence, déposée au-dessus d'une, voire directement sur une, couche de contact à base d'oxyde, notamment à base d'oxyde de zinc, éventuellement dopé, éventuellement à l'aluminium (le dopage s'entend d'une manière habituelle comme exposant une présence de l'élément dans une quantité inférieure à 10 % en masse d'élément métallique dans la couche et l'expression « à base de » s'entend d'une manière habituelle d'une couche contenant majoritairement le matériau, c'est-à-dire contenant au moins 50 % de ce matériau en masse ; l'expression « à base de » couvre ainsi le dopage).

L'épaisseur géométrique (ou réelle) de la couche de contact est de préférence comprise entre 3 et 30 nm et de préférence encore comprise entre 4 et 20 nm.

L'effet de la couche de contact dans le revêtement antireflet sous-jacent à la couche fonctionnelle métallique peut parfois être négligé notamment lorsque l'indice de cette couche est proche de celui du substrat et/ou lorsque cette couche présente une faible épaisseur, typiquement lorsqu'elle est inférieure à 10 nm.

La couche de contact peut être à base de nitrure métallique et peut alors se confondre alors la couche de fond, en particulier lorsque la couche de fond est à base de nitrure de silicium.

La couche de contact est, de préférence, à base de l'un au moins des oxydes métalliques suivants, éventuellement dopé : oxyde de chrome, oxyde d'indium, oxyde de zinc éventuellement sous stoechiométrique, oxyde d'aluminium, oxyde de titane, oxyde de molybdène, oxyde de zirconium, oxyde d'antimoine, oxyde d'étain, oxyde de tantale, oxyde de silicium (par simplification, le silicium est considéré ici comme un métal).

L'oxyde métallique peut être dopé typiquement, entre 0,5 et 5 %. Il s'agit en particulier d'oxyde de zinc dopé par Al (AZO), Ga (GZO), voire par B, Sc, ou Sb pour une meilleure stabilité de procédé de dépôt voire d'oxyde d'étain dopé par F ou S.

La couche de contact peut être à base d'oxyde mixte notamment d'un oxyde mixte de zinc et d'étain SnₓZn_{y}O_{z} généralement non stoechiométrique et sous phase amorphe, ou d'un oxyde mixte d'indium et d'étain (ITO), d'un oxyde mixte d'indium et de zinc (IZO).

On préfère une couche d'oxyde de zinc ZnOₓ, avec préférentiellement x inférieur à 1, encore plus préférentiellement compris entre de 0,88 à 0,98, notamment de 0,90 à 0,95. Cette couche peut être pure ou dopée par Al ou par Ga.

L'empilement est généralement obtenu par une succession de dépôts effectués par une technique utilisant le vide comme la pulvérisation cathodique éventuellement assistée par champ magnétique. Peuvent aussi être prévus un, voire deux, revêtement(s) très fin(s) appelé(s) « revêtement de blocage », disposé(s) directement sous, sur ou de chaque côté de chaque couche métallique fonctionnelle notamment à base d'argent, le revêtement sous-jacent à la couche fonctionnelle, en direction du substrat, en tant que revêtement d'accrochage, de nucléation et/ou de protection, et le revêtement sus-jacent à la couche fonctionnelle en tant que revêtement de protection ou « sacrificiel » afin d'éviter l'altération de la couche métallique fonctionnelle par attaque et/ou migration d'oxygène d'une couche qui le surmonte, voire aussi par migration d'oxygène si la couche qui le surmonte est déposée par pulvérisation cathodique en présence d'oxygène.

La couche métallique fonctionnelle peut ainsi être disposée directement sur au moins un revêtement de blocage sous-jacent et/ou directement sous au moins un revêtement de blocage sus-jacent, chaque revêtement présentant une épaisseur comprise de préférence entre 0,5 et 5 nm.

Au sens de la présente invention lorsqu'il est précisé qu'un dépôt de couche ou de revêtement (comportant une ou plusieurs couches) est effectué directement sous ou directement sur un autre dépôt, c'est qu'il ne peut y avoir interposition d'aucune couche entre ces deux dépôts.

Au moins un revêtement de blocage comprend, de préférence, une couche métallique, nitrure et/ou oxyde métallique, à base d'au moins l'un des métaux suivants : Ti, V, Mn, Fe, Co, Cu, Zn, Zr, Hf, Al, Nb, Ni, Cr, Mo, Ta, W, ou à base d'un alliage d'au moins un desdits matériaux.

Par exemple, un revêtement de blocage peut être constitué d'une couche à base de niobium, tantale, titane, chrome ou nickel ou d'un alliage à partir d'au moins deux desdits métaux, comme un alliage de nickel-chrome.

Une fine couche de blocage forme une couche de protection voire même une couche « sacrificielle » qui permet d'éviter l'altération du métal de la couche métallique fonctionnelle, notamment dans l'une et/ou l'autre des configurations suivantes :
- si la couche qui surmonte la couche fonctionnelle est déposée en utilisant un plasma réactif (oxygène, azote ...), par exemple si la couche d'oxyde qui la surmonte est déposée par pulvérisation cathodique,
- si la composition de la couche qui surmonte la couche fonctionnelle est susceptible de varier lors de la fabrication industrielle (évolution des conditions de dépôt type usure d'une cible etc.) notamment si la stoechiométrie d'une couche de type oxyde et/ou nitrure évolue, modifiant alors la qualité de la couche fonctionnelle et donc les propriétés de l'électrode (résistance carré, transmission lumineuse, ...),
- si le revêtement électrode subit postérieurement au dépôt un traitement thermique.

Cette couche protectrice voire sacrificielle améliore significativement la reproductibilité des propriétés électriques et optiques de l'électrode. Cela est très important pour une démarche industrielle où seule une faible dispersion des propriétés des électrodes est acceptable.

On préfère en particulier une fine couche de blocage à base d'un métal choisi parmi le niobium Nb, le tantale Ta, le titane Ti, le chrome Cr ou le nickel Ni ou d'un alliage à partir d'au moins deux de ces métaux, notamment d'un alliage de niobium et de tantale (Nb/Ta), de niobium et de chrome (Nb/Cr) ou de tantale et de chrome (Ta/Cr) ou de nickel et de chrome (Ni/Cr). Ce type de couche à base d'au moins un métal présente un effet de piégeage (effet « getter ») particulièrement important.

Une fine couche de blocage métallique peut être aisément fabriquée sans altérer la couche fonctionnelle. Cette couche métallique peut être de préférence déposée dans une atmosphère inerte (c'est-à-dire sans introduction volontaire d'oxygène ou d'azote) constituée de gaz noble (He, Ne, Xe, Ar, Kr). Il n'est pas exclu ni gênant qu'en surface cette couche métallique soit oxydée lors du dépôt ultérieur d'une couche à base d'oxyde métallique.

La telle fine couche de blocage métallique permet en outre d'obtenir une excellente tenue mécanique (résistance à l'abrasion, aux rayures notamment). Ceci est spécialement vrai pour des empilements qui subissent un traitement thermique, et donc une diffusion important d'oxygène ou d'azote lors de ce traitement.

Néanmoins, pour l'utilisation de couche de blocage métallique, il faut limiter l'épaisseur de la couche métallique et donc l'absorption lumineuse pour conserver une transmission lumineuse suffisante pour les électrodes transparentes.

La fine couche de blocage peut être partiellement oxydée. Cette couche est déposée sous forme non métallique et n'est donc pas déposée sous forme stoechiométrique, mais sous forme sous-stoechiométrique, du type MOₓ, où M représente le matériau et x est un nombre inférieur à la stoechiométrie de l'oxyde du matériau ou du type MNOₓ pour un oxyde de deux matériaux M et N (ou plus). On peut citer par exemple TiOₓ, NiCrOₓ.

x est de préférence compris entre 0,75 fois et 0,99 fois la stoechiométrie normale de l'oxyde. Pour un monoxyde, on peut notamment choisir x entre 0,5 et 0,98 et pour un dioxyde x entre 1,5 et 1,98.

Dans une variante particulière, la fine couche de blocage est à base de TiOₓ et x peut être en particulier tel que 1,5 ≤ x ≤ 1,98 ou 1,5 < x < 1,7, voire 1,7 ≤ x ≤ 1,95.

La fine couche de blocage peut être partiellement nitrurée. Elle n'est donc pas déposée sous forme stoechiométrique, mais sous forme sous-stoechiométrique, du type MN_{y}, où M représente le matériau et y est un nombre inférieur à la stoechiométrie de du nitrure du matériau. y est de préférence compris entre 0,75 fois et 0,99 fois la stoechiométrie normale du nitrure.

De la même manière, la fine couche de blocage peut aussi être partiellement oxynitrurée.

Cette fine couche de blocage oxydée et/ou nitrurée peut être aisément fabriquée sans altérer la couche fonctionnelle. Elle est, de préférence, déposée à partir d'une cible céramique, dans une atmosphère non oxydante constituée de préférence de gaz noble (He, Ne, Xe, Ar, Kr).

La fine couche de blocage peut être préférentiellement en nitrure et/ou oxyde sous-stoechiométrique pour encore davantage de reproductibilité des propriétés électriques et optiques de l'électrode.

La fine couche blocage choisie oxyde et/ou nitrure sous stoechiométrique peut être, de préférence à base d'un métal choisi parmi l'un au moins des métaux suivants : Ti, V, Mn, Fe, Co, Cu, Zn, Zr, Hf, Al, Nb, Ni, Cr, Mo, Ta, W, ou d'un oxyde d'un alliage sous stoechiométrique à base d'au moins un de ces matériaux.

On préfère en particulier une couche à base d'un oxyde ou d'oxynitrure d'un métal choisi parmi le niobium Nb, le tantale Ta, le titane Ti, le chrome Cr ou le nickel Ni ou d'un alliage à partir d'au moins deux de ces métaux, notamment d'un alliage de niobium et de tantale (Nb/Ta), de niobium et de chrome (Nb/Cr) ou de tantale et de chrome (Ta/Cr) ou de nickel et de chrome (Ni/Cr).

Comme nitrure métallique sous-stoechiométrique, on peut choisir aussi une couche en nitrure de silicium SiNₓ ou d'aluminium AlNx ou de chrome Cr Nₓ, ou de titane TiNₓ ou de nitrure de plusieurs métaux comme le NiCrNₓ.

La fine couche de blocage peut présenter un gradient d'oxydation, par exemple M(N)Oₓᵢ avec xᵢ variable, la partie de la couche de blocage en contact avec la couche fonctionnelle est moins oxydée que la partie de cette couche la plus éloignée de la couche fonctionnelle en utilisant une atmosphère de dépôt particulière.

Le revêtement de blocage peut aussi être multicouche et notamment comprendre :
- d'une part une couche « d'interface » immédiatement en contact avec ladite couche fonctionnelle, cette couche d'interface étant en un matériau à base d'oxyde, de nitrure ou d'oxynitrure métallique non stoechiométrique, tels que ceux précités,
- d'autre part, d'au moins une couche en un matériau métallique, tels que ceux précités, couche immédiatement en contact avec ladite couche « d'interface ».

La couche d'interface peut être un oxyde, un nitrure ou un oxynitrure d'un métal ou de métaux qui est ou sont présent(s) dans la couche métallique adjacente éventuelle.

La surcouche du revêtement électrode selon l'invention est, de préférence, à base de l'un au moins des oxydes métalliques suivants, éventuellement dopé : oxyde de chrome, oxyde d'indium, oxyde de zinc éventuellement sous stoechiométrique, oxyde d'aluminium, oxyde de titane, oxyde de molybdène, oxyde de zirconium, oxyde d'antimoine, oxyde d'étain, oxyde de tantale, oxyde de silicium et cette surcouche présente de préférence une épaisseur comprise entre 3 et 50 nm.

Cette surcouche peut par exemple être en oxyde d'étain dopé par F, Sb, ou en oxyde de zinc dopé à l'aluminium, ou être éventuellement à base d'un oxyde mixte notamment un oxyde mixte d'indium et d'étain, un oxyde mixte d'indium et de zinc, oxyde mixte de zinc et d'étain.

Le substrat selon l'invention revêtu de la couche de fond et du revêtement électrode présente, de préférence, une faible rugosité de telle sorte que l'écart de l'endroit le plus creux à l'endroit le plus haut (« peak to valley » en anglais) sur la surcouche soit inférieur ou égal à 10 nm.

Le substrat selon l'invention revêtu de la couche de fond et du revêtement électrode présente, de préférence, sur la surcouche une rugosité RMS inférieure ou égale à 3 nm, de préférence même inférieure ou égale à 2 nm et encore plus préférentiellement inférieure ou égale à 1,5 nm voire inférieure ou égale à 1 nm, afin d'éviter les défauts de pointes (« spike effect » en anglais) qui réduisent drastiquement la durée de vie et la fiabilité notamment de l'OLED.

La rugosité R.M.S signifie rugosité « Root Mean Square ». Il s'agit d'une mesure consistant à mesurer la valeur de l'écart quadratique moyen de la rugosité. Cette rugosité R.M.S, concrètement, quantifie donc en moyenne la hauteur des pics et creux de rugosité, par rapport à la hauteur moyenne. Ainsi, une rugosité R.M.S de 2 nm signifie une amplitude moyenne de pic double.

Elle peut être mesurée de différentes manières : par exemple, par microscopie à force atomique, par un système mécanique à pointe (utilisant par exemple les instruments de mesure commercialisés par la société VEECO sous la dénomination DEKTAK), par interférométrie optique La mesure se fait généralement sur un micromètre carré par microscopie à force atomique, et sur une surface plus importante, de l'ordre de 50 micromètres à 2 millimètres pour les systèmes mécaniques à pointe.

Cette faible rugosité est en particulier atteinte lorsque le substrat comporte entre la couche de fond et la couche de contact une couche de lissage non cristallisée en un oxyde mixte, ladite couche de lissage étant disposée immédiatement sous ladite couche de contact et étant en un autre matériau que celui de la couche de contact.

La couche de lissage est, de préférence, une couche d'oxyde mixte à base d'oxyde d'un ou de plusieurs des métaux suivants : Sn, Si, Ti, Zr, Hf, Zn, Ga, In et notamment est une couche d'oxyde mixte à base de zinc et d'étain éventuellement dopée ou une couche d'oxyde mixte d'indium et d'étain (ITO) ou une couche d'oxyde mixte d'indium et de zinc (IZO).

La couche de lissage présente, de préférence, une épaisseur géométrique entre 0,1 et 30 nm et de préférence encore comprise entre 0,2 et 10 nm.

Le substrat comporte par ailleurs, de préférence, une structure de bus-électrode inférieure au-dessus du revêtement électrode inférieur, ladite structure de bus-électrode étant en contact électrique avec ledit revêtement électrode.

La structure de bus-électrode inférieure se présente sous forme de couche pour l'amenée de courant avant la gravure ; elle est de préférence d'épaisseur comprise entre 0,5 à 10 µm et de préférence sous forme d'une monocouche en l'un des métaux suivants : Mo, Al, Cr, Nd ou en alliage tel que MoCr, AlNd ou sous forme d'une multicouche telle que MoCr/Al/MoCr.

Pour la réalisation d'un dispositif OLED, le substrat comporte dans l'ordre, en partant de la première face principale du substrat :
- un système OLED, au-dessus du revêtement électrode inférieur,
- un revêtement électrode supérieur au-dessus dudit système OLED ;
- une structure de bus-électrode supérieure au-dessus du revêtement électrode supérieur, ladite structure de bus-électrode étant en contact électrique avec ledit revêtement électrode supérieur.

Dans une variante particulière, l'ensemble formé par la couche de fond et le revêtement électrode inférieur est constitué d'un empilement pour vitrage architectural notamment « trempable » ou « à tremper », et/ou notamment un empilement bas-émissif, en particulier un empilement du type :
- couche de fond à base d'oxyde métallique et/ou à base de nitrure métallique / (couche d'arrêt de gravure) / (couche de lissage) / couche de contact en oxyde / (revêtement de sous-blocage) / couche métallique fonctionnelle / (revêtement de sur-blocage) / surcouche à base d'oxyde métallique et/ou de nitrure métallique
- couche de fond et de contact à base de nitrure métallique / (revêtement de sous-blocage) / couche métallique fonctionnelle / (revêtement de sur-blocage) / surcouche à base de nitrure métallique.

Dans une autre variante particulière, le substrat revêtu de la couche de fond et du revêtement électrode inférieur est constitué d'un substrat pour vitrage architectural notamment « trempable » ou « à tremper » revêtu d'un empilement de couches minces, et/ou notamment un empilement bas-émissif, ledit substrat n'étant, de préférence, pas trempé après le dépôt des couches minces.

Dans une variante supplémentaire, le substrat selon l'invention comporte sur une deuxième face principale un revêtement fonctionnel choisi parmi : une multicouche antireflet, une couche antibuée ou antisalissures, un filtre ultraviolet, notamment une couche d'oxyde de titane, une couche luminophore, une couche miroir, une zone diffusante d'extraction de lumière.

Le substrat plan peut être transparent (en particulier pour une émission à travers le susbtrat). Le substrat plan peut être rigide, flexible ou semi-flexible.

Le substrat plan est de préférence verrier, notamment en verre sodocalcique ou silicosodocalcique. Le substrat peut être avantageusement un verre présentant un coefficient d'absorption inférieur à 2,5 m⁻¹, de préférence inférieur à 0,7 m⁻¹ à la longueur d'onde du ou des rayonnements OLEDs.

On choisit par exemple des verres silicosodocalciques avec moins de 0,05% de Fe III ou de Fe₂O₃, notamment le verre Diamant de Saint-Gobain Glass, le verre Optiwhite de Pilkington, le verre B270 de Schott. On peut choisir toutes les compositions de verre extraclair décrites dans le document WO04/025334.

Dans une configuration choisie d'une émission du système OLED à travers l'épaisseur du substrat transparent, une partie du rayonnement émis est guidé dans le substrat.

Aussi, dans une conception avantageuse de l'invention, l'épaisseur du substrat choisi verrier peut être d'au moins 1 mm, de préférence d'au moins 5 mm, par exemple. Cela permet de diminuer le nombre de réflexions internes et d'extraire ainsi plus de rayonnement guidé dans le verre, augmentant ainsi la luminance de la zone lumineuse.

Le chant du substrat peut en outre être réfléchissant, et comporter de préférence un miroir, pour assurer un recyclage optimal du rayonnement guidé et/ou ce chant peut former avec la face principale associée au système OLED un angle interne supérieur à 90° et inférieur ou égal à 135°, de préférence de l'ordre de 100°, pour rediriger les rayonnements sur une plus large zone d'extraction. Le chant du substrat peut être ainsi biseauté.

Pour séparer électriquement les électrodes dans le document JP2005-038642, l'électrode inférieure est structurée en plusieurs étapes de gravure impliquant différents acides et à différentes vitesses de gravure. On grave ainsi d'abord la couche d'adaptation du travail de sortie, puis la couche métallique et enfin la couche d'adhésion.

Le but que se fixe l'invention est de parvenir à obtenir un assemblage de couches électroconductrices pour former une électrode fiable, robuste (notamment en termes de stabilité et/ou de tenue thermique, mécanique) sans sacrifier ses propriétés d'électroconductivité, sa qualité optique, ni les performances du dispositif l'incorporant, ni engendrer des difficultés de réalisation notamment de gravure humide.

L'invention propose ainsi un procédé de gravure acide d'une électrode multicouche sur un substrat notamment verrier comportant une couche de fond, de préférence à base de nitrure de silicium, oxyde de silicium ou oxynitrure de silicium.

L'invention concerne également le procédé de fabrication du substrat selon l'invention, selon lequel au moins la couche de fond et le revêtement électrode sont déposés sur le substrat, de préférence au moins en partie par une technique sous vide du type pulvérisation cathodique éventuellement assistée par champ magnétique, puis le substrat subi une gravure pour graver au moins le revêtement électrode en une seule étape.

Toutes les couches du revêtement électrodes sont de préférence déposées par une technique de dépôt sous vide, mais il n'est toutefois pas exclu que la première ou les premières couches de l'empilement puisse(nt) être déposée(s) par une autre technique, par exemple par une technique de décomposition thermique de type pyrolyse.

Dans le cadre du procédé de fabrication du substrat, si le revêtement électrode ne présente pas directement la structure d'électrode nécessaire, il subi une étape de gravure visant à réaliser une structure d'électrode, comme par exemple une étape de sérigraphie chimique (de préférence à l'acide) ou une étape de gravure par laser telle que celles déjà connues dans son principe pour les revêtements électrodes à base d'ITO.

Le revêtement électrode selon l'invention peut tout particulièrement être gravable par RIE (« Réactive ion etching » en anglais) ou encore plus préférentiellement par gravure humide (facilement intégrable dans la phase de fabrication et à pression atmosphérique).

L'ensemble des couches de la couche de contact à la surcouche, y compris la couche fonctionnelle, est, de préférence, gravé suivant un même motif de gravure et de préférence par une seule gravure, c'est-à-dire que la couche de fond, elle, n'est pas gravée. La couche d'arrêt de gravure, si elle est présente, est de préférence également intacte, mais peut se trouvée légèrement gravée, par exemple sur un dixième de son épaisseur initiale. Il en est de même pour la couche de fond si la couche d'arrêt de gravure n'est pas présente.

En outre, il est en général préférable de munir le revêtement électrode de bus électrode avant le dépôt du système OLED. La couche qui va former les bus-électrodes est, de préférence, gravée en même temps que le revêtement électrode.

L'invention propose ainsi un procédé de gravure acide d'une électrode multicouche sur un substrat notamment verrier comportant une couche d'arrêt de gravure acide, de préférence à base de nitrure et/ou oxyde de silicium, la gravure étant réalisée en une seule étape et avec une solution d'acide unique choisie parmi l'acide nitrique HNO₃ pur en ou mélange avec de l'acide chlorhydrique HCl ou l'acide chlorhydrique pur en ou mélange avec du trichlorure de fer FeCl₃ autrement dit chlorure de Fe III.

On peut ainsi graver à façon des motifs de gravure dont la largeur et l'espacement varient en fonction des applications.

La gravure peut être réalisée en présence d'au moins une bande métallique d'amenée de courant, sous forme d'une monocouche de préférence à base de l'un des métaux suivants Mo, Al, Cr, Nd ou en alliage tel que MoCr, AlNd ou en multicouche telle que MoCr/Al/MoCr.

L'invention a trait également à un dispositif électroluminescent organique comportant au moins un substrat porteur, notamment verrier, muni d'au moins une couche électroluminescente organique disposée entre l'électrode inférieure telle que décrite précédemment, la plus proche du substrat porteur et une électrode dite supérieure.

Le dispositif OLED peut produire de la lumière monochromatique, notamment bleue et/ou verte et/ou rouge, ou être adaptée pour produire une lumière blanche.

Pour produire de la lumière blanche plusieurs méthodes sont possibles : mélange de composés (émission rouge vert, bleu) dans une seule couche ; empilement sur la face des électrodes de trois structures organiques (émission rouge vert, bleu) ou de deux structures organiques (jaune et bleu) ; série de trois structures organiques adjacentes (émission rouge vert, bleu) ; sur la face des électrodes une structure organique dans une couleur et sur l'autre face des couches luminophores adaptées.

Le dispositif OLED peut comprendre une pluralité de systèmes électroluminescents organiques adjacents, chacun émetteur de lumière blanche ou, par série de trois, de lumière rouge, verte et bleu, les systèmes étant par exemple connectés en série.

Le dispositif peut faire partie d'un vitrage multiple, notamment un vitrage sous vide ou avec lame d'air ou autre gaz. Le dispositif peut aussi être monolithique, comprendre un vitrage monolithique pour gagner en compacité et/ou en légèreté.

Le système OLED peut être collé ou de préférence feuilleté avec un autre substrat plan dit capot, de préférence transparent tel qu'un verre, à l'aide d'un intercalaire de feuilletage, notamment extraclair.

Les vitrages feuilletés sont usuellement constitués de deux substrats rigides entre lesquels est disposée une feuille ou une superposition de feuilles de polymère du type thermoplastique. L'invention inclut aussi les vitrages feuilletés dits « asymétriques » utilisant un substrat notamment porteur rigide du type verre et comme substrat couvrant une ou des feuilles protectrices de polymère.

L'invention inclut aussi les vitrages feuilletés ayant au moins une feuille intercalaire à base d'un polymère adhésif simple ou double face du type élastomère (c'est-à-dire ne nécessitant pas une opération de feuilletage au sens classique du terme, feuilletage imposant un chauffage généralement sous pression pour ramollir et rendre adhérente la feuille intercalaire thermoplastique).

Dans cette configuration, le moyen pour solidariser capot et substrat porteur peut être alors un intercalaire de feuilletage notamment une feuille de matière thermoplastique par exemple en polyuréthane (PU), en polyvinylbutyral (PVB), en éthylène vinylacétate (EVA), ou être en résine pluri ou mono-composants réticulables thermiquement (époxy, PU) ou aux ultraviolets (époxy, résine acrylique). Elle est de préférence (sensiblement) de même dimension que le capot et le substrat.

L'intercalaire de feuilletage peut permettre d'éviter un fléchissement du capot notamment pour des dispositifs de grande dimension par exemple de surface supérieure à 0,5m².

L'EVA offre en particulier de multiples avantages :
- il n'est pas ou peu chargé en eau en volume,
- il ne nécessite pas nécessairement une mise sous pression élevée pour sa mise en oeuvre.

Un intercalaire de feuilletage thermoplastique peut être préféré à une couverture en résine coulée car elle est à la fois plus facile à mettre en oeuvre, plus économique et est éventuellement plus étanche.

L'intercalaire comporte éventuellement un réseau de fils électroconducteurs incrustés sur sa surface, dite interne, en regard de l'électrode supérieure, et/ou une couche électroconductrice ou des bandes électroconductrices sur la surface interne du capot.

Le système OLED peut être disposé de préférence à l'intérieur du double vitrage, avec une lame de gaz notamment inerte (argon par exemple).

L'électrode supérieure peut être une couche électroconductrice avantageusement choisie parmi les oxydes métalliques notamment les matériaux suivants :
- l'oxyde de zinc dopé, notamment à l'aluminium ZnO:Al ou au gallium ZnO:Ga,
- ou encore l'oxyde d'indium dopé, notamment à l'étain (ITO) ou l'oxyde d'indium dopé au zinc (IZO).

On peut utiliser plus généralement tout type de couche électroconductrice transparente, par exemple une couche dite « TCO » (pour « Transparent Conductive Oxyde » en anglais), par exemple d'épaisseur entre 20 et 1000 nm.

On peut aussi utiliser une couche mince métallique dite « TCC » (pour « Transparent conductive coating » en anglais) par exemple en Ag, Al, Pd, Cu, Pd, Pt In, Mo, Au et typiquement d'épaisseur entre 5 et 150 nm en fonction de la transmission/réflexion lumineuse souhaitée.

L'électrode n'est pas forcément continue. L'électrode supérieure peut comprendre une pluralité de bandes conductrices ou de fils conducteurs (grille).

En outre, il peut être avantageux d'ajouter un revêtement ayant une fonctionnalité donnée sur la face opposée du substrat porteur de l'électrode selon l'invention ou sur un substrat additionnel. Il peut s'agir d'une couche anti-buée (à l'aide d'une couche hydrophile), anti-salissures (revêtement photocatalytique comprenant du TiO₂ au moins partiellement cristallisé sous forme anatase), ou encore un empilement anti-reflet du type par exemple S₁₃N₄/SiO₂/Si₃N₄/SiO₂ ou encore un filtre aux UV comme par exemple une couche d'oxyde de titane (TiO₂). Il peut en outre s'agir d'une ou plusieurs couches luminophores, d'une couche miroir, d'au moins une zone diffusante d'extraction de lumière.

L'invention concerne également les diverses applications que l'on peut trouver à ces dispositifs OLEDS, formant une ou des surfaces lumineuses transparentes et/ou réfléchissantes (fonction miroir) disposés aussi bien en extérieur qu'en intérieur.

Le dispositif peut former (choix alternatif ou cumulatif) un système éclairant, décoratif, architectural, etc.), un panneau d'affichage de signalisation - par exemple du type dessin, logo, signalisation alphanumérique, notamment un panneau d'issue de secours.

Le dispositif OLED peut être arrangé pour produire une lumière uniforme, notamment pour un éclairage homogène, ou pour produire différentes zones lumineuses, de même intensité ou d'intensité distincte.

Inversement, on peut rechercher un éclairage différencié. Le système électroluminescent organique (OLED) produit une zone de lumière directe, et une autre zone lumineuse est obtenue par extraction du rayonnement OLED qui est guidé par réflexion totale dans l'épaisseur du substrat choisi verrier.

Pour former cette autre zone lumineuse, la zone d'extraction peut être adjacente au système OLED ou de l'autre côté du substrat. La ou les zones d'extraction peuvent servir par exemple pour renforcer l'éclairage fourni par la zone de lumière directe, notamment pour un éclairage de type architectural, ou encore pour signaler le panneau lumineux. La ou les zones d'extraction sont de préférence sous forme de bande(s) de lumière, notamment uniforme(s), et préférentiellement disposée(s) en périphérie d'une des faces. Ces bandes peuvent par exemple former un cadre très lumineux.

L'extraction est obtenue par l'un au moins des moyens suivants disposés dans la zone extraction : une couche diffusante, de préférence à base de particules minérales et de préférence avec un liant minéral, le substrat rendu diffusant, notamment texturé ou rugueux.

Les deux faces principales peuvent avoir chacune une zone de lumière directe.

Lorsque les électrodes et la structure organique du système OLED sont choisies transparentes, on peut réaliser notamment une fenêtre éclairante. L'amélioration de l'éclairage de la pièce n'est alors pas réalisée au détriment de la transmission lumineuse. En limitant en outre la réflexion lumineuse notamment du côté extérieur de la fenêtre éclairante, cela permet aussi de contrôler le niveau de réflexion par exemple pour respecter les normes anti-éblouissement en vigueur pour les façades de bâtiments.

Plus largement, le dispositif, notamment transparent par partie(s) ou entièrement, peut être :
- destiné au bâtiment, tel qu'un vitrage lumineux extérieur, une cloison lumineuse interne ou une (partie de) porte vitrée lumineuse notamment coulissante,
- destiné à un véhicule de transport, tel qu'un toit lumineux, une (partie de) vitre latérale lumineuse, une cloison lumineuse interne d'un véhicule terrestre, aquatique ou aérien (voiture, camion train, avion, bateau, etc.),

- destiné au mobilier urbain ou professionnel tel qu'un panneau d'abribus, une paroi d'un présentoir, d'un étalage de bijouterie ou d'une vitrine, une paroi d'une serre, une dalle éclairante,
- destiné à l'ameublement intérieur, un élément d'étagère ou de meuble, une façade d'un meuble, une dalle éclairante, un plafonnier, une tablette éclairante de réfrigérateur, une paroi d'aquarium,
- destiné au rétro-éclairage d'un équipement électronique, notamment d'écran de visualisation ou d'affichage, éventuellement double écran, comme un écran de télévision ou d'ordinateur, un écran tactile.

On peut par exemple concevoir un rétro-éclairage d'un écran double face avec des tailles différentes, l'écran de petite taille étant de préférence associé à une lentille de Fresnel pour concentrer la lumière.

Pour former un miroir éclairant, l'une des électrodes peut être réfléchissante ou un miroir peut être disposé sur la face opposée au système OLED, si l'on souhaite privilégier un éclairage d'un seul côté dans la zone de lumière directe.

Il peut être aussi un miroir. Le panneau lumineux peut servir à l'éclairage d'une paroi de salle de bains ou d'un plan de travail de cuisine, être un plafonnier.

Les OLED sont généralement dissociés en deux grandes familles suivant le matériau organique utilisé.

Si les couches électroluminescentes sont des petites molécules, on parle de SM-OLED (« Small Molecule Organic Light Emitting Diodes » en anglais). Le matériau électroluminescent organique de la couche mince est constitué à partir de molécules évaporées comme par exemple le complexe d'AlQ₃ (tris(8-hydroxyquinoline) aluminium), le DPVBi (4,4'-(diphényl vinylène biphényl)), le DMQA (diméthyl quinacridone) ou le DCM (4-(dicyanométhylène)-2-méthyl-6-(4-diméthylaminostyryl)-4H-pyran). La couche émissive peut être aussi par exemple une couche de 4,4*'*,4*"*-tri(N-carbazolyl) triphenylamine (TCTA) dopé au fac tris(2-phenylpyridine) iridium [Ir(ppy)₃].

D'une manière générale la structure d'une SM-OLED consiste en un empilement de couches d'injection de trous ou « HIL » pour « Hole Injection Layer » en anglais, couche de transport de trous ou « HTL » pour « Hole Transporting Layer » en anglais, couche émissive, couche de transport d'électron ou « ETL » pour « Electron Transporting Layer » en anglais.

Un exemple de couche d'injection de trous est le phthalocyanine de cuivre (CuPC), la couche de transport de trous peut être par exemple le N,N'-Bis(naphthalen-1-yl)-N,N'-bis(phenyl)benzidine (alpha-NPB).

La couche de transport d'électrons peut être composée de tris-(8-hydroxyquinoline) aluminium (Alq₃) ou le bathophenanthroline (BPhen).

L'électrode supérieure peut être une couche de Mg/Al ou LiF/Al.

Des exemples d'empilements électroluminescents organiques sont par exemple décrits dans le document US6645645.

Si les couches électroluminescentes organiques sont des polymères, on parle de PLED (« Polymer Light Emitting Diodes » en anglais).

Le matériau électroluminescent organique de la couche mince est constitué à partir de polymères (pLEDs) comme par exemple le PPV pour poly(para-phénylène vinylène), le PPP (poly(*para*-phénylène), le DO-PPP (poly(2-décyloxy-1,4-phénylène), le MEH-PPV (poly[2-(2'-éthylhexyloxy)-5-méthoxy-1,4-phénylène vinylène)]), le CN-PPV (poly[2,5-bis(hexyloxy)-1,4-phénylène-(1-cyanovinylène)]) ou les PDAF (poly(dialkylfluorène), la couche de polymère est associée également à une couche qui favorise l'injection des trous (HIL) constituée par exemple du PEDT/PSS (poly (3,4-ethylène-dioxythiophène/ poly(4-styrène sulfonate)).

Un exemple de PLED consiste en un empilement suivant :
- une couche de poly(2,4-ethylene dioxythiophene) dopé au poly(styren sulphonate) (PEDOT :PSS) de 50nm,
- une couche de phenyl poly (p-phenylenevynilene) Ph-PPV de 50nm.

L'électrode supérieure peut être une couche de Ca.

L'invention sera maintenant décrite plus en détails à l'aide d'exemples non limitatifs et de figures :
- La figure 1 est une vue schématique en coupe d'un dispositif électroluminescent organique, pour un (rétro)éclairage uniforme, lequel comprend une électrode inférieure conforme à l'invention dans un premier mode de réalisation,
- la figure 2 est une vue partielle montrant cette électrode inférieure plus en détail,
- la figure 3 illustre un procédé de fabrication et de gravure de cette électrode,
- la figure 4 illustre une vue schématique en coupe d'un dispositif électroluminescent organique, pour un (rétro)éclairage uniforme, lequel est arrangé sur plusieurs zones, et comprend une électrode inférieure conforme à l'invention dans un deuxième mode de réalisation,
- les figures 5 et 6 illustrent des vues schématiques de dessus montrant deux schémas de connexions électriques d'électrodes similaires à celles utilisées dans le deuxième mode de réalisation,
- la figure 7 représente une vue schématique en coupe latérale d'un dispositif électroluminescent organique utilisé pour un éclairage différencié.

On précise que par un souci de clarté les différents éléments des objets (y compris les angles) représentés ne sont pas nécessairement reproduits à l'échelle.

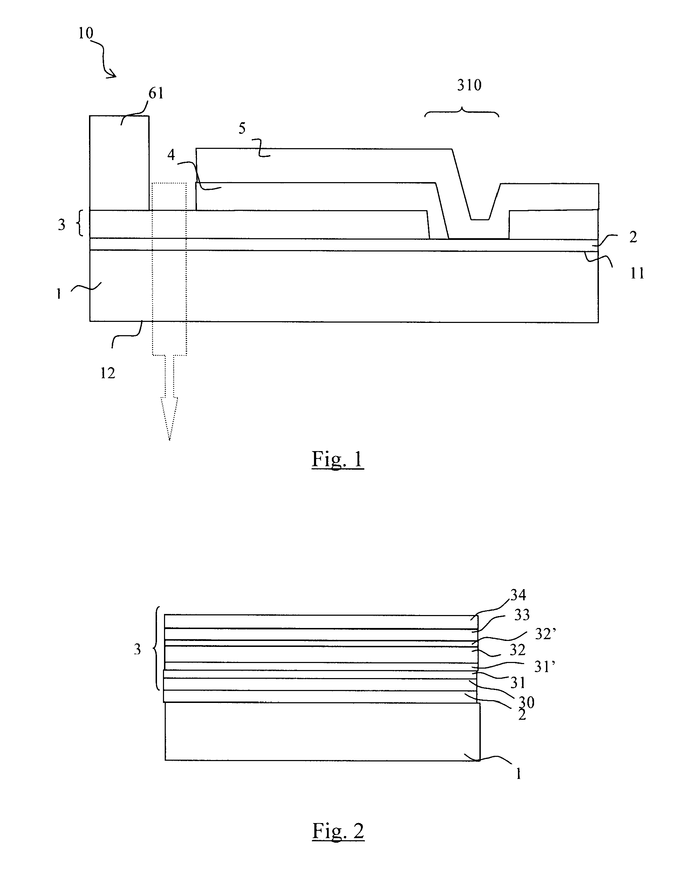

La figure 1 est volontairement très schématique. Elle représente en coupe un dispositif électroluminescent organique 10 (à émission à travers le substrat ou « bottom émission » en anglais) comprenant successivement :
- un substrat plan 1 de verre silico-sodo-calcique clair ou extraclair de 2,1 mm d'épaisseur, avec des première et deuxième faces principales 11, 12, la première face principale 11 comportant :
- une couche de fond 2, déposée directement sur la première face principale 11, faisant office également d'arrêt de gravure, en nitrure de silicium d'épaisseur entre 10 nm et 80 nm et couvrant sensiblement la totalité de la première face principale 11,
- une électrode inférieure (ou revêtement électrode) 3, déposée directement sur la couche de fond 2, gravée, choisie transparente, comportant un empilement de couches (voir figure 2) du type :
   - une couche de contact 31 choisie parmi ZnOₓ dopée ou non, Sn_{y}Zn_{z}Oₓ, ITO ou IZO,
   - une couche fonctionnelle 32 en argent de préférence pur,
   - éventuellement un revêtement de blocage 32' sus-jacent, directement sur la couche fonctionnelle 32,
   - une couche de protection 33 choisie parmi ZnOₓ, Sn_{y}Zn_{z}Oₓ, ITO ou IZO, la couche de contact et la couche de protection contre l'eau et/ou l'oxygène étant de nature identique,
   - une surcouche 34, notamment d'adaptation du travail de sortie,
   soit de préférence l'empilement ZnO:Al/Ag/Ti ou NiCr // ZnO:Al / ITO, d'épaisseurs respectives 5 à 20 nm pour ZnO:Al, 5 à 15 nm pour l'argent, 0,5 à 2 nm pour Ti ou NiCr, 5 à 20 nm, pour le ZnO:Al, 5 à 20 nm pour L'ITO,
- un système électroluminescent organique 4, par exemple un SM-OLED de structure suivante :
   - une couche en alpha-NPD,
   - une couche en TCTA + Ir(ppy)₃,
   - une couche en BPhen,
   - une couche en LiF,
- une électrode supérieure réfléchissante 5, notamment métallique notamment à base d'argent ou d'aluminium.

Une série d'exemples de dépôt d'empilements pour réaliser la couche de fond 2 et le revêtement 3 a été réalisée par pulvérisation cathodique assistée par champ magnétique, à température ambiante, en général sur un substrat 1 de 4 mm d'épaisseur.

Le tableau ci-après résume la nature et l'épaisseur en nanomètres des différentes couches de ces exemples, ainsi que les principales caractéristiques de ces exemples.

La rugosité RMS (ou Rq) a été mesurée par microscopie à force atomique. Les conditions de dépôt pour chacune des couches sont les suivantes :
- les couches à base de Si₃N₄:Al sont déposées par pulvérisation réactive à l'aide d'une cible en silicium dopée à l'aluminium, sous une pression de 0,25 Pa dans une atmosphère argon/azote,
- les couches à base de SnZn:SbOₓ sont déposées par pulvérisation réactive à l'aide d'une cible de zinc et d'étain dopée à l'antimoine comportant en masse 65 % de Sn, 34 % de Zn et 1 % de Sb, sous une pression de 0,2 Pa et dans une atmosphère argon/oxygène,
- les couches à base d'argent sont déposées à l'aide d'une cible en argent, sous une pression de 0,8 Pa dans une atmosphère d'argon pur,
- les couches de Ti sont déposées à l'aide d'une cible titane, sous une pression de 0,8 Pa dans une atmosphère d'argon pur,
- les couches à base de ZnO:Al sont déposées par pulvérisation réactive à l'aide d'une cible de zinc dopé aluminium, sous une pression de 0,2 Pa et dans une atmosphère argon/oxygène,
- les surcouches à base d'ITO sont déposées à l'aide d'une cible céramique dans une atmosphère argon/oxygène, sous une pression de 0,2 Pa et dans une atmosphère argon/oxygène.

| Exemples | 1 | 2 | 3 | 4 | 5* | 6* | 7 |
|---|---|---|---|---|---|---|---|
| Couches | | | | | | | |
| SiO₂ | | | | | | 150nm | |
| ITO | | | | | | 90nm | |
| 2:Si₃N₄:A | 20 | 25 | 26 | 21 | 21 | | 20 |
| 30:SnZn:SbOₓ | | | | 5 | 5 | | |
| 31 : ZnO:Al | 20 | 10 | 5 | 5 | 5 | | 20 |
| 32 : Ag | 12 | 12 | 12 | 12 | 12 | | 30 |
| 32' : Ti | | 1 | 1 | 1 | 0,5 | | |
| 33 : ZnO:Al | 40 | 20 | 20 | 20 | | | 40 |
| 34 : ITO | 20 | 20 | 20 | 20 | 10 | | 20 |
| | | | | | | | |
| T_{L} (%) | 75 | 83 | 85 | 85 | 65 | 85 | 16 |
| R_{L} (%) | 15 | 8 | 5 | 8 | 29 | 10 | 81 |
| Abs (%) | 10 | 9 | 10 | 7 | 6 | 5 | 3 |
| Résistance par carré (Ω/carré) | 4,5 | 4,4 | 3,5 | 3,3 | 3,5 | 20 | 0,9 |
| Rugosité RMS (nm) | 1,2 | 1,3 | 0,9 | 0,7 | 0,7 | 1 | 1,3 |
| Performance OLED (coordonnées x et y) ** | | | | | 20 (0,43 ; 0,45) | 15 (0,43 ; 0,43) | |
| Durée de vie à 1000cd/m² (en heures) | | | | | 25000 | 15000 | |

| | | | | | | | |
|---|---|---|---|---|---|---|---|
| * Sur un substrat en verre sodo-calcique de 0,7 mm. ** : à 1000 cd/m², avec système OLED optimisé (en lm/W), pour une lumière blanche émise présentant des coordonnées x et y, mesurées dans le système de colorimétrie CIE xy qui sont proches de l'illuminant A visé de x = 0,45 et y = 0,41. | | | | | | | |

Avec cette structure, l'électrode de l'invention permet d'améliorer le rendement en lm/W de l'OLED d'au moins 5 à 10%, voire 15 et même jusqu'à 20 %, pour une brillance supérieure à 500 cd/m² par rapport à une électrode en ITO.

La première électrode (l'électrode inférieure) peut en variante comprendre un revêtement de blocage sous-jacent 31', comportant notamment, comme le revêtement de blocage sus-jacent 32', une couche métallique obtenue de préférence par une cible métallique avec un plasma neutre ou en nitrure et/ou oxyde d'un ou plusieurs métaux tels que Ti, Ni, Cr, obtenue de préférence par une cible céramique avec un plasma neutre.

Dans les exemples 1 à 6, l'électrode est une électrode transparente, avec une transmission lumineuse du substrat revêtu ≥ 50 % et comprise entre 50 % et 90 %. Pour les exemples selon l'invention 1 à 4, cette transmission lumineuse est élevée puisqu'elle est comprise entre 75 et 85 %. Pour l'exemple 5, qui est aussi selon l'invention, la transmission lumineuse est certes moins élevée, quoique toujours supérieure à 50 %, mais ce n'est pas forcément un inconvénient car l'absorption est très basse. Ces exemples 1 à 6 ne peuvent pas être utilisés comme électrode réfléchissante car leur réflexion lumineuse est inférieure à 70 %, ni comme électrode transparente/réfléchissante car leur rapport T_{L} sur R_{L} n'est pas entre 0,1 et 0,7.

Dans les exemples 4 et 5, l'électrode transparente comporte une couche de lissage 30, alors qu'il n'y en a pas pour les exemples 1 à 3. Cette couche de lissage permet de diminuer la rugosité de l'ensemble de l'empilement d'environ 10 %, mesurée sur la surcouche 34, tout en améliorant la résistance par carré de l'empilement d'environ 5 %.

L'exemple 5 constitue un exemple qui a été optimisé afin de permettre de le comparer à un contre-exemple, l'exemple 6, à électrode en TCO (ITO). Comme visible dans le tableau précédent, toutes les caractéristiques de résistance par carré, de rugosité, de performance et de durée de vie de l'exemple 5 ont été augmentées par rapport à celle de l'exemple 6.

Dans l'exemple 7, le substrat revêtu peut être utilisé comme électrode transparente/réfléchissante puisque ce substrat revêtu présente un rapport T_{L} sur R_{L} de 0,2, qui est ainsi entre 0,1 et 0,7. Ce substrat revêtu présente par ailleurs une transmission lumineuse inférieure à 50 % et n'est donc pas acceptable pour réaliser une électrode transparente mais il pourrait toutefois être accepté aussi pour réaliser une électrode réfléchissante puisque sa réflexion lumineuse est supérieure à 70 %.

La première électrode peut aussi être une électrode essentiellement réfléchissante.

L'électrode inférieure 3 déborde sur un côté du substrat 1. La bordure de la surcouche 34 est ainsi surmontée d'une première bande métallique 61 d'amenée de courant, de préférence d'épaisseur comprise entre 0,5 à 10 µm, par exemple 5 µm, et sous forme d'une couche en l'un des métaux suivants : Mo, Al, Cr, Nd ou en alliage tel que MoCr, AlNd ou en multicouche tel que MoCr/Al/MoCr.

L'électrode inférieure 3 peut en variante comprendre une structure répétée n fois, avec n un nombre entier supérieur ou égal à 1, cette structure étant la suivante : la couche de contact/la couche fonctionnelle/(la fine couche de blocage)/( la couche de protection à l'eau et/ou à l'oxygène).

Cette structure est surmontée d'une séquence comprenant la couche de contact/la couche fonctionnelle/(la couche de protection à l'eau et/ou à l'oxygène)/ladite surcouche.

Dans le cas d'un empilement de structures organiques par exemple émettant dans le rouge, le vert, le bleu, pour produire une lumière blanche, on peut par ailleurs répéter trois fois l'ensemble des éléments 3, 4, 5 ou bien simplement utiliser une multicouche Al/ITO ou Ag/éventuellement une fine couche de blocage similaire/ITO ou Ag/éventuellement une fine de couche blocage similaire/ZnO/ITO pour les électrodes inférieures supplémentaires.

L'électrode supérieure déborde sur le côté opposé du substrat 1. Cette bordure de l'électrode supérieure 5 est éventuellement surmontée d'une deuxième bande métallique d'amenée de courant, de préférence similaire à la première bande métallique. Cette deuxième bande est préférable dans le cas où l'électrode supérieure est d'épaisseur inférieure ou égale à 50 nm.

La deuxième électrode peut en effet aussi être, en variante, une électrode transparente ou semi transparente et par exemple être identique ou similaire à la première électrode. On rapporte éventuellement dans ce cas un réflecteur sur la deuxième face 12 par exemple une couche métallique d'épaisseur 150 nm.

Une feuille type EVA peut permettre de feuilleter le substrat 1 à un autre verre de préférence de mêmes caractéristiques que le substrat 1. Optionnellement, la face 12 du verre 1 tournée vers la feuille d'EVA est munie d'un empilement de fonctionnalité donnée décrite plus tard.

L'électrode inférieure 3 est en deux parties espacées par la zone de gravure 310.

La gravure humide est utilisée pour séparer électriquement l'électrode inférieure 3 de l'électrode supérieure 5 du dispositif 10.

Pour graver la totalité de l'électrode inférieure (couche de contact, couche fonctionnelle, éventuelle couche ou revêtement de blocage sus-jacent, éventuelle couche de protection et surcouche) suivant un même motif de gravure et en une fois, on expose les couches - préalablement en partie masquées à l'aide d'une bande adhésive résistante aux l'acides ou en variante avec un masque de photolithographie - à l'une des solutions acides suivantes :
- à l'HCl (par exemple à 40%),
- ou à l'HCl (par exemple à 4%),
- ou à un mélange de HCl (par exemple à 4%) et de HNO₃ (par exemple à 7 %),
- ou à un mélange de HCl et de FeCl₃,
- à l'HNO₃ entre 10 et 18%.

La gravure à l'acide chlorhydrique conduit à des profils de gravure très homogènes. Le mélange acide nitrique et acide chlorhydrique donne aussi des résultats intéressants. Le mélange de HCl et FeCl₃ est utilisé de manière classique pour L'ITO.

Le profil de gravure, le temps de gravure et la résolution peuvent être adaptés en utilisant des mélanges des deux acides et en jouant sur les concentrations.

On peut ainsi graver à façon des motifs de gravure dont la largeur et l'espacement varient en fonction des applications.

Pour des écrans OLED à matrice passive de petite taille (pour affichage d'un matériel électronique de type téléphone portable, afficheur, assistant personnel, lecteur MP3, ...), la largeur de chaque zone gravée peut être typiquement de 10 à 20 µm, chaque zone gravée étant espacée de 10 à 50 µm par exemple de 35 µm (correspondant à la largeur de chaque zone d'électrode).

Pour des écrans OLED à matrice passive de grande taille, par exemple pour affichage publicitaire, signalétique, la largeur de chaque zone gravée peut être de l'ordre de 0,5 mm et la largeur de chaque zone d'électrode peut être de quelques mm, quelques cm ou plus, ...

Pour un éclairage homogène, la largeur de chaque zone gravée peut être inférieure ou égale à 100 µm, encore plus préférentiellement à 50 µm quelle que soit la taille de l'écran.

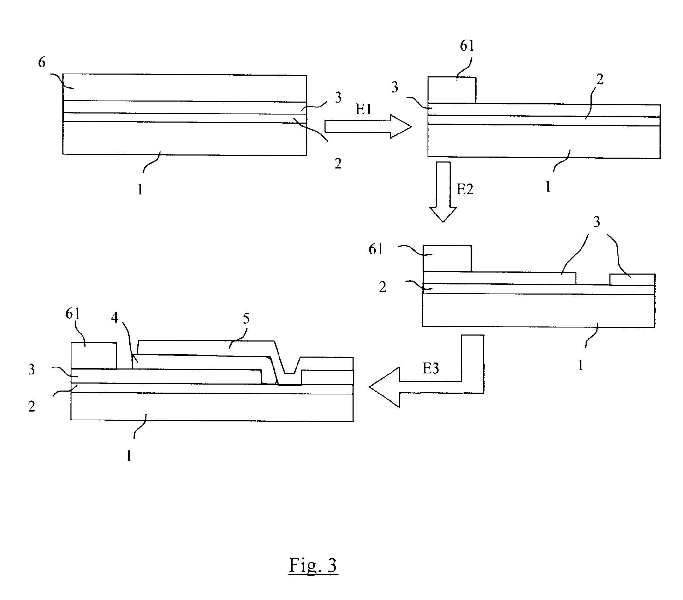

La figure 3 illustre un procédé de fabrication et de gravure de cette électrode.

Après dépôt de la couche de fond 2, de l'électrode 3 et de la couche métallique (mono ou multicouche) pour l'amenée de courant 6, on procède à la gravure de cette couche 6 avec une solution qui ne grave pas l'électrode par exemple de la soude (étape E1), puis on procède à la gravure en une étape de l'électrode inférieure 3 comme déjà indiqué (étape E2), suivi du dépôt du système OLED 4 et de l'électrode supérieure 5 par exemple en Al au-dessus (étape E3).

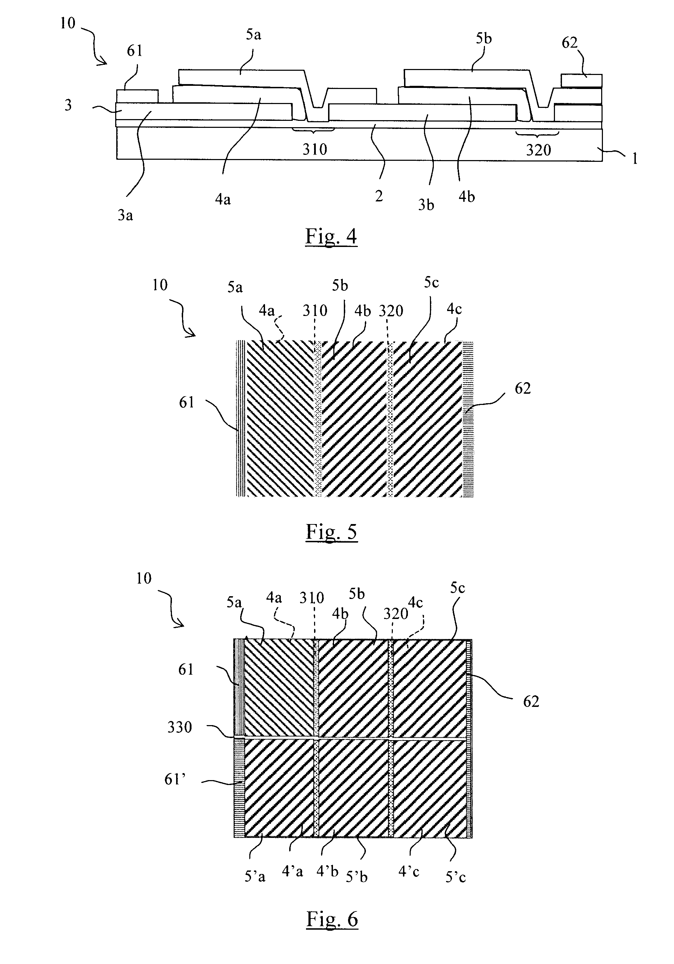

La figure 4 illustre une vue schématique en coupe d'un dispositif électroluminescent organique 10, pour un (rétro)éclairage uniforme, lequel est arrangé sur plusieurs zones, et comprend une électrode inférieure conforme à l'invention dans un deuxième mode de réalisation.

Ce deuxième dispositif diffère du premier dispositif par les éléments décrits ci après.

Le dispositif 10 illustré sur la figure 4 comprend deux systèmes électroluminescents organiques 4a et 4b adjacents, chacun émetteur de lumière de préférence blanche ou, en variante par série de trois, de lumière rouge, verte et bleue. Les systèmes 4a et 4b sont connectés en série. L'électrode inférieure est divisée principalement en deux rectangles ou carrés 3a, 3b d'une dizaine de cm de coté chacun dépassant par un côté (gauche sur la figure) du système OLED. Ces zones d'électrodes sont séparées par la zone de gravure 310. La deuxième zone d'électrode 3b est séparée par la zone de gravure 320 d'une zone d'électrode inférieure « résiduelle » (à droite de la figure). La première section d'électrode inférieure 3a est recouverte partiellement par une première bande métallique formant « bus bar » réalisant une structure de bus-électrode 61.

L'électrode supérieure est également divisée. La première section d'électrode supérieure 5a, dépasse vers le côté droit et recouvre le bord gauche de la deuxième section d'électrode inférieure 3b. La deuxième section d'électrode supérieure 5b dépasse vers le côté droit et recouvre le bord gauche de la section d'électrode inférieure résiduelle et est recouverte par une deuxième bande métallique formant « bus bar » réalisant une structure de bus-électrode 62.

Les zones de gravure 310, 320 sont par exemple des bandes de largeur de 20 à 50 µm pour être quasi invisibles à l'oeil nu.

Les figures 5 et 6 illustrent des vues schématiques de dessus montrant deux schémas de connexions électriques d'électrodes similaires à celles qui sont utilisées dans le deuxième mode de réalisation.

Dans la figure 5, trois systèmes électroluminescents organiques 4a à 4c sont connectés en série. Les zones de gravure 310 et 320 sont des bandes de largeur de 20 à 50 µm pour être quasi invisibles à l'oeil nu.

L'électrode inférieure est divisée en 3 rectangles d'une dizaine de cm de largeur chacun dépassant par un côté (gauche sur la figure). Ils sont séparés par les zones de gravure 310, 320. L'électrode supérieure 5a à 5c est également divisée en trois. La première section d'électrode inférieure est recouverte partiellement par une première bande métallique formant « bus bar » réalisant une structure de bus-électrode 61.

Les deux premières sections d'électrode supérieure 5a, 5b dépassent vers le côté droit et recouvre le bord gauche de la section d'électrode inférieure adjacente. La troisième section d'électrode supérieure 5c, dépasse vers le côté droit et recouvre le bord gauche d'une section d'électrode inférieure résiduelle et est recouverte partiellement par une deuxième bande métallique formant « bus bar » réalisant une structure de bus-électrode 62.

Dans la figure 6, six systèmes électroluminescents organiques 4a à 4c, 4'a à 4'c sont connectés en deux séries parallèles entre elles (une série de trois système 4a à 4c en haut de la figure et une série de trois systèmes 4a' à 4c'en bas de la figure). Les zones de gravure 310 à 330 sont à la fois latérales 310, 320 et longitudinales 330, et sont des bandes de largeur de 20 à 50 µm pour être quasi invisibles à l'oeil nu.

L'électrode inférieure est divisée en six carrés d'une dizaine de cm de côté chacun dépassant par un côté (gauche sur la figure). Les sections d'électrode inférieure sont séparées par les zones de gravure 310 à 330. La première bande formant bus bar est coupée pour former un collecteur de courant avec deux bandes de deux structures de bus-électrode 61, 61' du côté gauche de la figure.

L'électrode supérieure 5a à 5c, 5'a à 5'c est également divisée en six. Les deux premières sections hautes (en haut à gauche sur la figure) de l'électrode supérieure 5a à 5b dépassent vers le côté droit et recouvre le bord gauche de la troisième section de l'électrode inférieure adjacente.

La troisième section haute d'électrode supérieure 5b dépasse vers le côté droit et recouvre le bord gauche de la section d'électrode inférieure résiduelle et est recouverte par une bande métallique réalisant une structure de bus-électrode 62 et formant une interconnexion électrique entre les troisièmes sections supérieures 5c, et 5c' d'électrode (à droite sur la figure).

Les deux premières sections basses (en bas à gauche sur la figure) de l'électrode supérieure 5'a à 5'b dépassent vers le côté droit et recouvre le bord gauche de la troisième section basse de l'électrode inférieure adjacente.

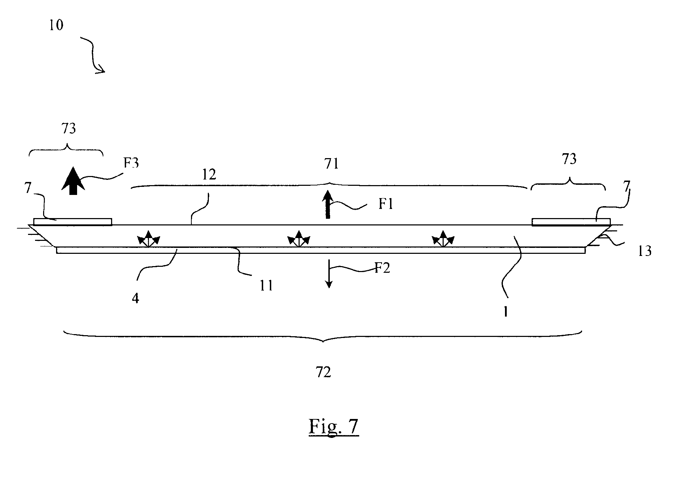

La figure 7 représente une vue schématique en coupe latérale d'un dispositif électroluminescent organique 10 utilisé pour un éclairage différencié.

Ce dispositif 10 comprend d'abord un substrat 1 transparent plan, constitué de préférence une feuille en verre de préférence épaisse, par exemple de 4 ou 6 mm, et avec un coefficient d'absorption inférieur ou égal à 2,5 m⁻¹ dans le visible. On choisit de préférence un verre sodocalcique extraclair, de coefficient d'absorption inférieur à 0,7 m⁻¹ dans le visible. Ce verre est doté de première et deuxième faces principales parallèles 12, 11 et d'un chant 13. Le dispositif est refermé dans sa partie inférieure par un capot, non illustré ici.

Le dispositif électroluminescent 10 de type OLED inclut un système OLED 4 disposé une électrode inférieure de type ZnO:Al_{20 nm}/Ag _{12 nm}/Ti₁ₙₘ/ ZnO:Al _{20 nm}/ITO _{20 nm} sur une couche de fond en Si₃N₄ de 25 nm agencée sur la première face principale 11. On définit des premières zones de lumière directe 71, 72 de part et d'autre du substrat 1.

La première zone de lumière directe 71, du côté opposé au système OLED 4 par rapport au substrat 1, couvre la partie centrale de la deuxième face principale 12. La deuxième zone de lumière directe 72, du côté du système OLED 4, s'étend au-dessous de toute la première face principale 11.

On adapte les caractéristiques du dispositif 10 pour que la luminance L1 de la première zone de lumière directe 71 soit de préférence supérieure à la luminance L2 de la deuxième zone de lumière directe 72 (comme symbolisé par la flèche épaisse F1 et la flèche mince F2).

Pour avoir L1 supérieure à L2, le dispositif 10 est donc à émission principale par l'électrode inférieure. Par exemple on choisit L1 égale à environ 1000 cd/m² et L2 égale à environ 500 cd/m² pour un confort visuel.

Le dispositif 10 est aussi une source de rayonnement guidé dans l'épaisseur du substrat 1, par réflexion totale. Le rayonnement guidé est extrait des bords de la deuxième face 12 au moyen d'une couche diffusante 7 par exemple à base de particules diffusantes minérales dispersés dans un liant minéral. On définit ainsi une troisième zone de lumière 73 formant un cadre lumineux périphérique. En variante, la couche diffusante 7 forme uniquement des bandes latérales ou des bandes longitudinales périphériques.

Pour favoriser l'extraction du rayonnement guidé, chacun des bords formant le chant 13 forme avec la première face principale 11 un angle interne supérieur à 90° et d'environ 100° et comporte un miroir, par exemple une couche métallique argent ou cuivre.

La luminance L3 de la troisième zone de lumière 73 est de préférence supérieure à la luminance L1 de la première zone de lumière directe 71 (comme symbolisé par la flèche très épaisse F3).

Le dispositif 10 peut être destiné au bâtiment, être une fenêtre éclairante, une porte éclairante, une paroi de serre ou une verrière ou encore être une vitre latérale de véhicule ou un toit lumineux. La deuxième face 12 est la face intérieure (face la plus éclairante).

Lorsque le dispositif 10 est allumé, la zone de lumière directe 71, centrale peut être apte à préserver l'intimité d'une personne à l'intérieur d'une pièce, d'un habitacle la nuit ou dans un environnement sombre. Il suffit pour cela que le flux lumineux envoyé par le vitrage soit au moins égal à celui réfléchi et renvoyé par la pièce.

Le dispositif 10 peut former un double vitrage, le dispositif 10étant de préférence situé dans l'espace rempli de gaz interne entre le substrat 1 et un verre additionnel éventuellement plus mince.

Le dispositif 10 ainsi conçu peut aussi servir d'étagère transparente et éclairante, de tablette lumineuse de réfrigérateur, de cloison transparente et éclairante entre deux pièces, de paroi d'un aquarium. On peut alors adapter les caractéristiques du dispositif 10 pour que la luminance L1 de la première zone de lumière directe 71 soit sensiblement égale à la luminance L2 de la deuxième zone de lumière directe 72.

Les zones de lumière 71, 72 sont uniformes. Le dispositif 10 peut aussi avoir, en variante, au moins une zone de lumière directe discontinue et/ou formant un dessin, un logo, une signalisation.

### FONCTIONS ADDITIONNELLES

Comme déjà dit, il peut être judicieux de fonctionnaliser la deuxième face du substrat 1 porteur (côté opposé au système électroluminescent organique).

On dépose ainsi à la surface des couches minces destinées à leur conférer une propriété particulière, comme par exemple celle qui consiste à permettre au substrat de rester le plus propre possible, quelles que soient les agressions environnementales, c'est-à-dire visant la permanence dans le temps des propriétés d'aspect et de surface, et permettant notamment d'espacer les nettoyages, en parvenant à éliminer au fur et à mesure les salissures se déposant progressivement à la surface du substrat, notamment les salissures d'origine organique comme les traces de doigts ou des produits organiques volatils présents dans l'atmosphère, ou même des salissures du type suie, poussières de pollution.

On connaît, dans le domaine des substrats à fonction de vitrage, l'utilisation de revêtements photo-catalytiques sur substrat, qui présentent un effet « anti-salissures » marqué et que l'on peut fabriquer de manière industrielle. Ces revêtements photo-catalytiques comportent généralement de l'oxyde de titane au moins partiellement cristallisé, incorporé audit revêtement sous forme de particules, notamment de taille comprise entre quelques nanomètres (3 ou 4) et 100 nm, préférentiellement voisin de 50 nm, pour l'essentiel cristallisées sous forme anatase ou anatase/rutile.

L'oxyde de titane fait en effet partie des semi-conducteurs qui, sous l'action de la lumière dans le domaine visible ou des ultraviolets, dégradent des produits organiques qui se déposent à leurs surfaces.

Ainsi selon un premier exemple de réalisation, le revêtement à propriété photo-catalytique résulte d'une solution à base de nanoparticules de TiO₂ et d'un liant de silice (SiO₂) mésoporeux.

Selon un deuxième exemple de réalisation, le revêtement à propriété photo-catalytique résulte d'une solution à base de nanoparticules de TiO₂ et d'un liant de silice (SiO₂) non structuré.

Quelle que soit la forme de réalisation du revêtement photo-catalytique, au niveau des particules d'oxyde de titane, le choix s'est porté, en outre, sur de l'oxyde de titane qui est au moins partiellement cristallisé parce qu'il a été montré qu'il était beaucoup plus performant en terme de propriété photo-catalytique que l'oxyde de titane amorphe. De préférence, il est cristallisé sous forme anatase, sous forme rutile ou sous forme d'un mélange d'anatase et de rutile.

Le revêtement à propriété photo-catalytique peut comporter également, outre l'oxyde de titane, au moins un autre type de matériau minéral, notamment sous forme d'un oxyde amorphe ou partiellement cristallisé, par exemple en oxyde de silicium (ou mélange d'oxydes), de titane, d'étain, de zirconium ou d'aluminium. Ce matériau minéral peut aussi participer à l'effet photo-catalytique de l'oxyde de titane cristallisé, en présentant lui-même un certain effet photo-catalytique, même faible par rapport à celui du TiO₂ cristallisé, ce qui est le cas de l'oxyde de titane amorphe ou partiellement cristallisé.

L'épaisseur du revêtement est variable, elle est comprise entre quelques nanomètres et quelques micromètres, typiquement comprise 50 nm et 10 µm.

En fait, le choix de l'épaisseur peut dépendre de différents paramètres, notamment de l'application envisagée du substrat, ou encore de la taille des cristallites de TiO₂ dans le revêtement. Le revêtement peut également être choisi de surface plus ou moins lisse : une faible rugosité de surface peut en effet être avantageuse, si elle permet de développer une surface photo-catalytique active plus grande. Cependant, trop prononcée, elle peut être pénalisante en favorisant l'incrustation, l'accumulation des salissures.

Selon une autre variante, la fonctionnalité qui est rapportée sur l'autre face du substrat peut être constituée par un revêtement antireflet.

Sont données ci-après les gammes préférées des épaisseurs géométriques et des indices des quatre couches de l'empilement antireflet, cet empilement étant dénommé A :
- n₁ et/ou n₃ sont compris entre 2,00 et 2,30, notamment entre 2,15 et 2,25, et préférentiellement voisin de 2,20.
- n₂ et/ou n₄ sont compris entre 1,35 et 1,65.
- e₁ est compris entre 5 et 50 nm, notamment entre 10 et 30 nm, ou entre 15 et 25 nm.
- e₂ est compris entre 5 et 50 nm, notamment inférieur ou égal à 35 nm ou à 30 nm, en étant notamment compris entre 10 et 35 nm.
- e₃ est compris entre 40 et 180 nm et préférentiellement entre 45 et 150 nm.
- e₄ est compris entre 45 et 110 nm et préférentiellement entre 70 et 105 nm.

Les matériaux les plus appropriés pour constituer la première et/ou la troisième couche de l'empilement A qui est de type antireflet, celles à haut indice, sont à base de nitrure de silicium ou de zirconium ou d'un mélange de ces nitrures. En variante, ces couches à haut indice sont à base de nitrures de silicium ou de tantale ou d'un mélange de ces derniers. Tous ces matériaux peuvent être éventuellement dopés pour améliorer leurs propriétés de résistance chimique et/ou mécanique et/ou électrique.

Les matériaux les plus appropriés pour constituer la seconde et/ou la quatrième couche de l'empilement A, celles à bas indice, sont à base d'oxyde de silicium, d'oxynitrure et/ou d'oxycarbure de silicium ou encore à base d'un oxyde mixte de silicium et d'aluminium. Un tel oxyde mixte tend à avoir une meilleure durabilité, notamment chimique, que du SiO₂ pur (Un exemple en est donné dans le brevet EP 791 562). On peut ajuster la proportion respective des deux oxydes pour obtenir l'amélioration de durabilité escomptée sans trop augmenter l'indice de réfraction de la couche.

Une forme préférée de réalisation de cet empilement antireflet est de la forme substrat/Si₃N₄/SiO₂/Si₃N₄/SiO₂.

Il va de soi que l'invention s'applique de la même manière aux systèmes utilisant d'autres systèmes électroluminescents que ceux décrits dans les exemples.

La présente invention est décrite dans ce qui précède à titre d'exemple. Il est entendu que l'homme du métier est à même de réaliser différentes variantes de l'invention sans pour autant sortir du cadre du brevet tel que défini par les revendications.

## Revendications

1. Substrat (1) pour dispositif électroluminescent organique (10), notamment substrat verrier transparent, comportant sur une première face principale (11) un revêtement électrode (3) inférieur, le revêtement électrode (3) étant constitué d'un empilement de couches minces comportant successivement au moins :
une couche de contact (31) à base d'oxyde métallique et/ou de nitrure métallique,
une couche fonctionnelle métallique (32) à propriété intrinsèque de conductivité électrique, la couche fonctionnelle (32) est à base d'un matériau pur choisi parmi l'argent, l'or, l'aluminium, le cuivre, ou à base dudit matériau allié ou dopé avec un autre matériau choisi parmi : Ag, Au, Pd, Al, Pt, Cu, Zn, Cd, In, Si, Zr, Mo, Ni, Cr, Mg, Mn, Co, Sn, notamment est à base d'un alliage or et argent ou d'un alliage or et cuivre
une surcouche (34) à base d'oxyde métallique et/ou de nitrure métallique, notamment d'adaptation du travail de sortie pour ledit revêtement électrode,
**caractérisé en ce qu**'il comporte une couche de fond (2), ladite couche de fond (2) couvrant ladite face principale (11).

2. Substrat (1) selon la revendication 1, ***caractérisé en ce que*** la couche de fond (2) est une couche en un matériau à base d'oxyde de silicium, d'oxycarbure de silicium, à base de nitrure de silicium, d'oxynitrure de silicium, d'oxycarbonitrure de silicium, le matériau de ladite couche de fond étant éventuellement dopé et ladite couche de fond présentant de préférence une épaisseur comprise entre 10 et 150 nm.

3. Substrat (1) selon l'une quelconque des revendications précédentes, ***caractérisé en ce qu'***il présente sur la surcouche (34) une rugosité RMS inférieure ou égale à 3 nm, de préférence inférieure ou égale à 2 nm, voire inférieure ou égale à 1 nm.

4. Substrat (1) selon l'une quelconque des revendications précédentes, ***caractérisé en ce que*** la couche de contact (31) est à base de l'un au moins des oxydes métalliques suivants, éventuellement dopé : oxyde de chrome, oxyde d'indium, oxyde de zinc éventuellement sous stoechiométrique, oxyde d'aluminium, oxyde de titane, oxyde de molybdène, oxyde de zirconium, oxyde d'antimoine, oxyde d'étain, oxyde de tantale, oxyde de silicium **et en ce que** la couche de contact présente de préférence une épaisseur comprise entre 3 et 30 nm.

5. Substrat (1) selon l'une quelconque des revendications précédentes, ***caractérisé en ce que*** la surcouche (34) est à base de l'un au moins des oxydes métalliques suivants, éventuellement dopé : oxyde de chrome, oxyde d'indium, oxyde de zinc éventuellement sous stoechiométrique, oxyde d'aluminium, oxyde de titane, oxyde de molybdène, oxyde de zirconium, oxyde d'antimoine, oxyde d'étain, oxyde de tantale, oxyde de silicium **et en ce que** la surcouche présente de préférence une épaisseur comprise entre 3 et 50 nm.

6. Substrat (1) selon l'une quelconque des revendications précédentes, ***caractérisé en ce que*** la couche métallique fonctionnelle (32) est disposée directement sur au moins un revêtement de blocage (31') sous-jacent et/ou directement sous au moins un revêtement de blocage (32') sus-jacent et
au moins un revêtement de blocage (31', 32') comprend une couche métallique, nitrure et/ou oxyde métallique, à base d'au moins l'un des métaux suivants : Ti, V, Mn, Fe, Co, Cu, Zn, Zr, Hf, Al, Nb, Ni, Cr, Mo, Ta, W, ou à base d'un alliage d'au moins un desdits matér.

7. Substrat (1) selon l'une quelconque des revendications précédentes, ***caractérisé en ce qu'***il comporte entre la couche de fond (2) et la couche de contact (31) une couche de lissage (30) non cristallisée en un oxyde mixte, ladite couche de lissage (30) étant disposée immédiatement sous ladite couche de contact (31) et étant en un matériau autre que celui de la couche de contact.

8. Substrat (10) selon la revendication précédente, ***caractérisé en ce que*** la couche de lissage (30) est une couche d'oxyde mixte à base d'oxyde d'un ou de plusieurs des métaux suivants : Sn, Si, Ti, Zr, Hf, Zn, Ga, In et notamment est une couche d'oxyde mixte à base de zinc et d'étain éventuellement dopée ou une couche d'oxyde mixte d'indium et d'étain (ITO) ou une couche d'oxyde mixte d'indium et de zinc (IZO).

9. Substrat (1) selon l'une quelconque des revendications précédentes, ***caractérisé en ce que*** sur la couche de fond (2) et une éventuelle couche d'arrêt de gravure, est agencé n fois la structure suivante, avec n un nombre entier supérieur ou égal à 1 : la couche de contact (31), la couche métallique fonctionnelle (32), la structure étant surmontée d'une séquence comprenant la succession constituée au moins de : couche de contact (31) / couche métallique fonctionnelle (32) / surcouche (34).

10. Utilisation d'un empilement de couches minces pour vitrage architectural, notamment un empilement bas-émissif et/ou notamment un empilement « trempable » ou « à tremper », pour réaliser un substrat (1) pour un dispositif électroluminescent organique (10), en particulier un substrat selon l'une quelconque des revendications précédentes, ledit substrat, notamment verrier transparent, comportant sur une première face principale (11) un revêtement électrode (3) inférieur, le revêtement électrode (3) étant constitué d'un empilement de couches minces comportant successivement au moins :
une couche de contact (31) à base d'oxyde métallique et/ou de nitrure métallique,
une couche fonctionnelle métallique (32) à propriété intrinsèque de conductivité électrique, la couche fonctionnelle (32) étant à base d'un matériau pur choisi parmi l'argent, l'or, l'aluminium, le cuivre, ou à base dudit matériau allié ou dopé avec un autre matériau choisi parmi : Ag, Au, Pd, Al, Pt, Cu, Zn, Cd, In, Si, Zr, Mo, Ni, Cr, Mg, Mn, Co, Sn, notamment est à base d'un alliage or et argent ou d'un alliage or et cuivre
une surcouche (34) à base d'oxyde métallique et/ou de nitrure métallique, notamment d'adaptation du travail de sortie pour ledit revêtement électrode,
ledit substrat comportant une couche de fond (2), ladite couche de fond (2) couvrant ladite face principale (11).

11. Dispositif électroluminescent organique (10) à émission par le haut et/ou par le bas incorporant un substrat (1) selon l'une quelconque des revendications 1 à 9 ou un substrat (1) utilisé la revendication 10.

12. Dispositif électroluminescent organique (10) selon la revendication 11 **caractérisé en ce qu'**il forme une ou des surfaces lumineuses transparentes et/ou réfléchissantes, notamment un système éclairant, décoratif, architectural, un panneau d'affichage de signalisation par exemple du type dessin, logo, signalisation alphanumérique, le système produisant une lumière uniforme ou des zones lumineuses différenciées notamment par extraction de lumière guidée dans le substrat verrier.

13. Dispositif électroluminescent organique (10) selon l'une des revendications 11 à 12 **caractérisé en ce qu'**il est :
- destiné au bâtiment, tel qu'un vitrage lumineux extérieur, une cloison lumineuse interne ou une (partie de) porte vitrée lumineuse notamment coulissante,
- destiné à un véhicule de transport, tel qu'un toit lumineux, une (partie de) vitre latérale lumineuse, une cloison lumineuse interne d'un véhicule terrestre, aquatique ou aérien.
- destiné au mobilier urbain ou professionnel tel qu'un panneau d'abribus, une paroi d'un présentoir ou d'une vitrine, une paroi d'une serre, une dalle éclairante,
- destiné à l'ameublement intérieur, tel qu'un élément d'étagère ou de meuble, une façade d'un meuble, une dalle éclairante, un plafonnier, une tablette éclairante de réfrigérateur, une paroi d'aquarium,
- destiné au rétro-éclairage d'un équipement électronique, notamment d'un écran de visualisation ou d'affichage éventuellement double écran, comme un écran de télévision ou d'ordinateur, un écran tactile,
- un miroir éclairant, notamment pour l'éclairage d'une paroi de salle de bains ou d'un plan de travail de cuisine, ou pour être un plafonnier.

14. Procédé de fabrication du substrat (1) selon l'une quelconque des revendications 1 à 9, ***caractérisé en ce qu'***au moins la couche de fond (2) et le revêtement électrode (3) sont déposés sur le substrat, de préférence au moins en partie par une technique sous vide du type pulvérisation cathodique éventuellement assistée par champ magnétique, puis ***en ce que*** le substrat subi une gravure.

15. Procédé selon la revendication précédente, **caractérisé en ce *que*** la gravure est une gravure acide, cette gravure étant réalisée en une étape et avec une solution d'acide choisie parmi l'acide nitrique HNO₃ pur en ou mélange avec de l'acide chlorhydrique HCl, ou l'acide chlorhydrique pur ou en mélange avec du trichlorure de fer FeCl₃.
